# EUROPEAN PATENT APPLICATION

(11) **EP 4 697 512 A1**
(43) Date of publication of application: **18.02.2026**
(21) Application number: 25194307.2
(22) Date of filing: 06.08.2025
(51) Int. Cl.: H01R 12/62, H01R 12/70, H01R 13/405, H01R 13/66, H01B 7/08, H01R 13/6591, H01R 24/60, H05K 3/34, H01R 12/71, H01R 13/6592

(54) **CONNECTOR ASSEMBLY AND FLAT CABLE**

(30) Priority: 09.08.2024 CN 202421934658 U
(71) Applicant: Tyco Electronics (Shanghai) Co., Ltd., Pilot Free Trade Zone Shanghai 200131 (CN); Tyco Electronics Technology (SIP) Co., Ltd., Suzhou 215126 (CN)
(72) Inventor: Wu, Ping, Shanghai, 200233 (CN); Zhou, Rui, Suzhou, 32 215101 (CN); Zhao, Fuying, Suzhou, 32 215101 (CN); Li, Shanlin, Suzhou, 32 215123 (CN)
(74) Representative: Grünecker Patent- und Rechtsanwälte PartG mbB

(57) **Abstract**

The present invention discloses a connector assembly and a flat cable. The connector assembly includes: a circuit board; a connector including a housing and a plurality of terminals disposed in the housing; a flat cable including a row of core wires and an inner insulation layer wrapping the row of core wires; and an insulator. Rear end of the terminals protrudes from the housing and is electrically connected to the circuit board, front end of the row of core wires is exposed from the inner insulation layer and is welded to the circuit board. The insulator is injection-molded onto the circuit board, the rear ends of the terminals and the front ends of the core wires through an embedded injection molding process, such that the insulator, the circuit board, the terminals and the core wires form an integral part. In the present invention, the flat cable has the advantage of small volume, easy handling and convenient welding, and enables automatic production, thereby improving the production efficiency and reducing the manufacturing costs. Furthermore, in some embodiments of the present invention, the flat cable further has a shield layer, which can ensure the stability of signal transmission of the connector assembly.

## Description

### CROSS-REFERENCE TO RELATED APPLICATION

This application claims the benefit of Chinese Patent Application No. CN202421934658.5 filed on August 9, 2024 in the State Intellectual Property Office of China, the whole disclosure of which is incorporated herein by reference.

### BACKGROUND OF THE INVENTION

### Field of the Invention

The present invention relates to a flat cable and a connector assembly including the flat cable.

### Description of the Related Art

In the prior art, a wire harness for a Type C connector typically includes a plurality of circular conductors, which need to be welded to a circuit board one by one, and each of the circular conductors needs to be clamped and fixed during welding, resulting in a complex welding process and difficulty in automatic production. In addition, the plurality of circular conductors are bound together disorderly, resulting in the disadvantages of large volume and difficulty in identification. In the prior art, each of the circular conductors includes, from the inside to the outside, a core wire, an inner insulation layer, an aluminum foil layer, a braided layer and an outer insulation layer. Before welding, it is necessary to peel off the outer insulation layer, bend and cut the braided layer, remove the aluminum foil layer and cut off the inner insulation layer. This results in a complex and time-consuming welding process for the circular conductors, thus reducing the production efficiency and increasing the manufacturing costs.

### SUMMARY OF THE INVENTION

The present invention has been made to overcome or alleviate at least one aspect of the above-mentioned disadvantages.

According to an aspect of the present invention, there is provided a connector assembly. The connector assembly includes: a circuit board; a connector including a housing and a plurality of terminals disposed in the housing; a flat cable including a row of core wires and an inner insulation layer wrapping the row of core wires; and an insulator. Rear end of the plurality of terminals protrudes from the housing and is electrically connected to the circuit board, and front end of the row of core wires is exposed from the inner insulation layer and is welded to the circuit board. The insulator is injection-molded onto the circuit board, the rear end of the plurality of terminals and the front end of the row of core wires through an embedded injection molding process, such that the insulator, the circuit board, the plurality of terminals and the row of core wires form an integral part.

According to an exemplary embodiment of the present invention, a row of pad is formed on the circuit board, and the front end of the row of core wires of the flat cable is welded to the row of pads of the circuit board respectively.

According to another exemplary embodiment of the present invention, the row of core wires of the flat cable includes a plurality of different types of core wires having different cross-sections and/or sizes; and the row of pads includes a plurality of different types of pads corresponding to the plurality of different types of core wires respectively.

According to another exemplary embodiment of the present invention, the row of core wires of the flat cable includes a flat core wire having a rectangular cross-section and a circular core wire having a circular cross-section; and the row of pads includes a first pad corresponding to the flat core wire and a second pad corresponding to the circular core wire.

According to another exemplary embodiment of the present invention, a width of the flat core wire is greater than a diameter of the circular core wire, and a thickness of the flat core wire is equal to the diameter of the circular core wire; and a width of the first pad is greater than a width of the second pad, and a thickness of the first pad is equal to a thickness of the second pad.

According to another exemplary embodiment of the present invention, the row of core wires includes a single flat core wire and a plurality of circular core wires, and the single flat core wire is a first core wire or a last core wire in the row of core wires.

According to another exemplary embodiment of the present invention, the plurality of terminals of the connector are arranged in an upper row and a lower row, the rear end of the terminals in the upper row is welded to a front side of the circuit board, and the rear end of the terminals in the lower row is welded to a back side of the circuit board.

According to another exemplary embodiment of the present invention, the connector is a Type-C connector conforming to a Type-C interface standard.

According to another exemplary embodiment of the present invention, the connector further includes a shield case sleeved on the housing, and a rear end of the shield case is sleeved and locked to the insulator to fix the connector to a front end of the insulator.

According to another exemplary embodiment of the present invention, the flat cable further includes: a shield layer wrapping around the inner insulation layer; and an outer insulation layer wrapping around the shield layer. The connector assembly further includes: a shield cover mounted on the insulator. The rear end of the shield case is inserted into a front end of the shield cover and is in electric contact with the front end of the shield cover, and a rear end of the shield cover is crimped onto the shield layer of the flat cable that is exposed from the outer insulation layer.

According to another exemplary embodiment of the present invention, a crimping portion is formed at the rear end of the shield cover, and the crimping portion is crimped onto the shield layer of the flat cable.

According to another exemplary embodiment of the present invention, an elastic latch is formed on the front end of the shield cover, an engagement groove is formed in the rear end of the shield case, and the elastic latch is locked into the engagement groove to lock the rear end of the shield case to the front end of the shield cover.

According to another exemplary embodiment of the present invention, an inwardly protruding contact protrusion is formed on the shield cover, an opening is formed on the insulator, a part of the circuit board is exposed from the opening, and the contact protrusion of the shield cover is engaged into the opening of the insulator and in electric contact with the circuit board.

According to another exemplary embodiment of the present invention, the shield cover includes an upper shield cover and a lower shield cover assembled together, an elastic piece is formed on a side wall of one of the upper shield cover and the lower shield cover, a snap slot is formed in the other one of the upper shield cover and the lower shield cover, and the elastic piece is locked into the snap slot to lock the upper shield cover and the lower shield cover together.

According to another exemplary embodiment of the present invention, the connector assembly further includes an outer insulating shell sleeved on the shield cover and having a front port and a rear port opposite each other in an axial direction thereof, and the flat cable is led out from the rear port of the outer insulating shell, and a part of the connector extends out of the front port of the outer insulating shell.

According to another exemplary embodiment of the present invention, the connector assembly further includes a rear end cover sleeved on the flat cable and locked onto a rear end of the outer insulating shell to retain the flat cable to the outer insulating shell.

According to another exemplary embodiment of the present invention, the rear end cover includes: a fixing portion configured to be locked onto the rear end of the outer insulating shell; and a buffer portion extending rearwardly from the fixing portion and capable of elastic deformation, the flat cable passes through the buffer portion, and the buffer portion is configured to provide stress buffer for the flat cable to prevent the flat cable from being damaged by bending.

According to another aspect of the present invention, there is provided a flat cable. The flat cable includes: a row of core wires; and an inner insulation layer wrapping the row of core wires. One end of the row of core wires is exposed from the inner insulation layer and is configured to be welded to a circuit board of a connector assembly, and the row of core wires includes a plurality of different types of core wires having different cross-sections and/or sizes.

According to an exemplary embodiment of the present invention, the row of core wires includes a flat core wire having a rectangular cross-section and a circular core wire having a circular cross-section.

According to another exemplary embodiment of the present invention, the flat cable further includes: a shield layer wrapping around the inner insulation layer; and an outer insulation layer wrapping around the shield layer, and one end of the shield layer is exposed from the outer insulation layer and is configured to be electrically connected to a shield cover of the connector assembly.

In the aforementioned various exemplary embodiments according to the present invention, the flat cable has the advantage of small volume, easy handling and convenient welding, and enables automatic production, thereby improving the production efficiency and reducing the manufacturing costs.

Furthermore, in some of the aforementioned exemplary embodiments according to the present invention, the flat cable further has a shield layer, which can ensure the stability of signal transmission of the connector assembly.

### BRIEF DESCRIPTION OF THE DRAWINGS

The above and other features of the present invention will become more apparent by describing in detail exemplary embodiments thereof with reference to the accompanying drawings, in which:
Figure 1 shows an illustrative perspective view of a connector assembly according to an exemplary embodiment of the present invention;
Figure 2 shows an illustrative exploded view of a connector assembly according to an exemplary embodiment of the present invention;
Figure 3 shows another illustrative exploded view of a connector assembly according to an exemplary embodiment of the present invention;
Figure 4 shows an illustrative perspective view of a connector assembly according to an exemplary embodiment of the present invention, in which an outer insulating shell and a rear end cover are removed;
Figure 5 shows an illustrative perspective view of an electrical connection module and a shield cover of the connector assembly according to an exemplary embodiment of the present invention;
Figure 6 shows an illustrative perspective view of an electrical connection module of a connector assembly according to an exemplary embodiment of the present invention;
Figure 7 shows an illustrative perspective view of an electrical connection module of a connector assembly according to an exemplary embodiment of the present invention, with an insulator not shown;
Figure 8 shows an illustrative perspective view of a circuit board and a flat cable of a connector assembly according to an exemplary embodiment of the present invention;
Figure 9 shows an illustrative exploded view of a circuit board and a flat cable of a connector assembly according to an exemplary embodiment of the present invention; and
Figure 10 shows a cross-sectional view of a flat cable of a connector assembly according to an exemplary embodiment of the present invention.

### DETAILED DESCRIPTION OF PREFERRED EMBODIMENTS OF THE INVENTION

Exemplary embodiments of the present disclosure will be described hereinafter in detail with reference to the attached drawings, wherein the like reference numerals refer to the like elements. The present disclosure may, however, be embodied in many different forms and should not be construed as being limited to the embodiment set forth herein; rather, these embodiments are provided so that the present disclosure will be thorough and complete, and will fully convey the concept of the disclosure to those skilled in the art.

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

According to a general concept of the present invention, there is provided a connector assembly. The connector assembly includes: a circuit board; a connector including a housing and a plurality of terminals disposed in the housing; a flat cable including a row of core wires and an inner insulation layer wrapping the row of core wires; and an insulator. Rear end of the plurality of terminals protrudes from the housing and are electrically connected to the circuit board, and front end of the row of core wires is exposed from the inner insulation layer and is welded to the circuit board. The insulator is injection-molded onto the circuit board, the rear end of the plurality of terminals and the front end of the row of core wires through an embedded injection molding process, such that the insulator, the circuit board, the plurality of terminals and the row of core wires form an integral part.

According to another general concept of the present invention, there is provided a flat cable. The flat cable includes: a row of core wires; and an inner insulation layer wrapping the row of core wires. One end of the row of core wires is exposed from the inner insulation layer and is configured to be welded to a circuit board of a connector assembly, and the row of core wires includes a plurality of different types of core wires having different cross-sections and/or sizes.

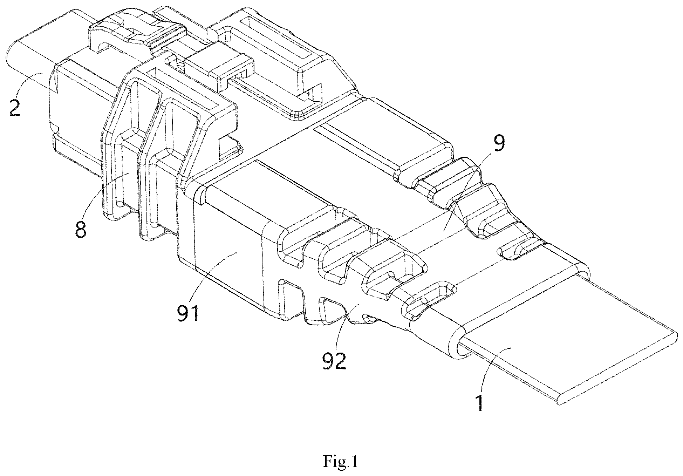

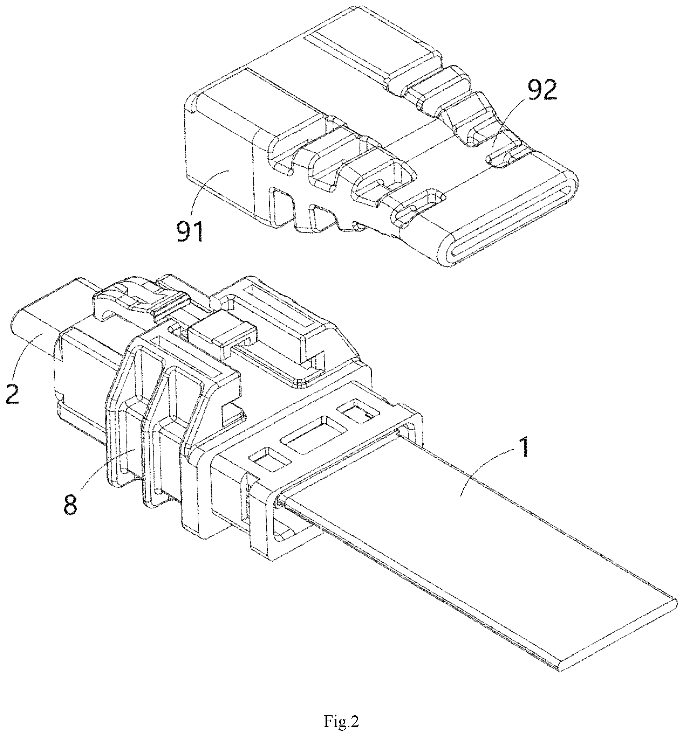

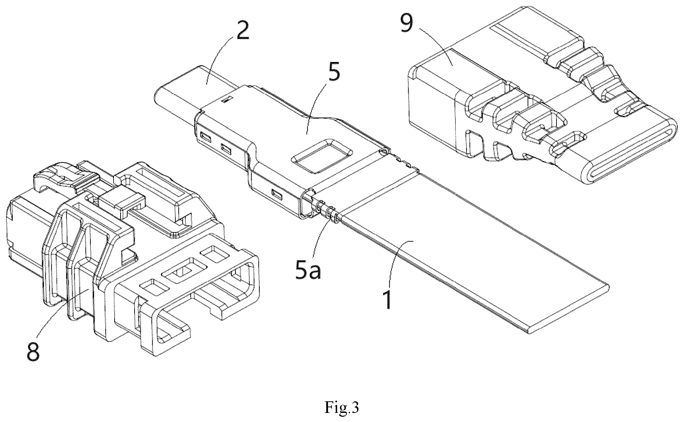

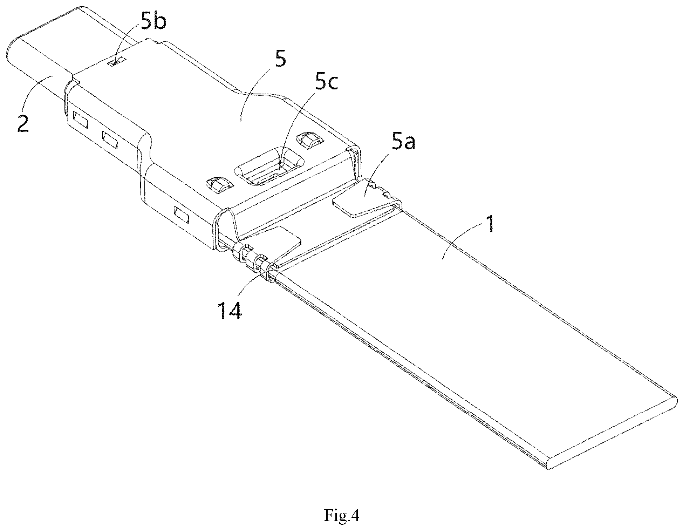

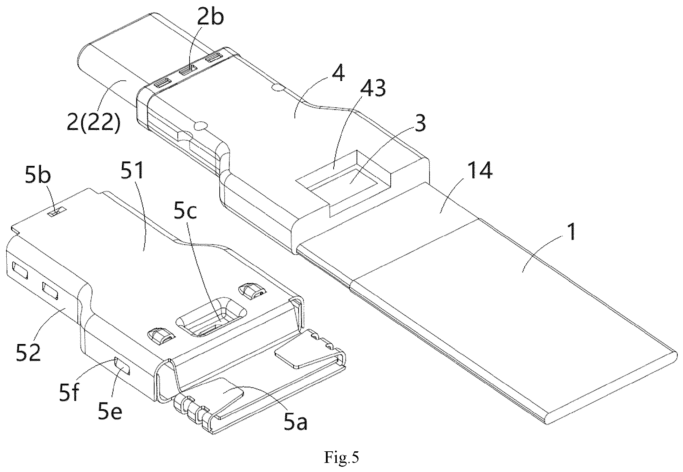

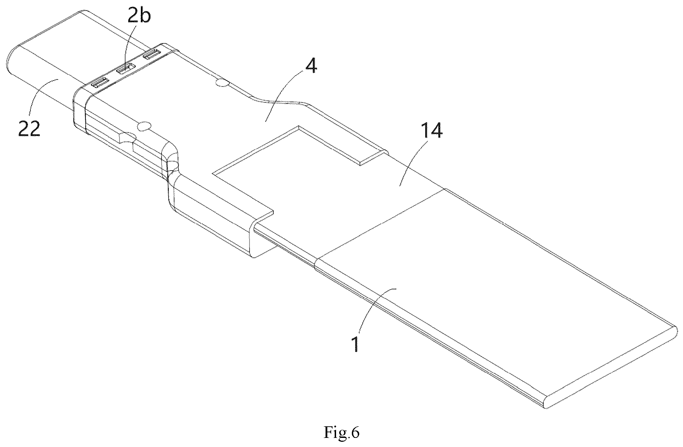

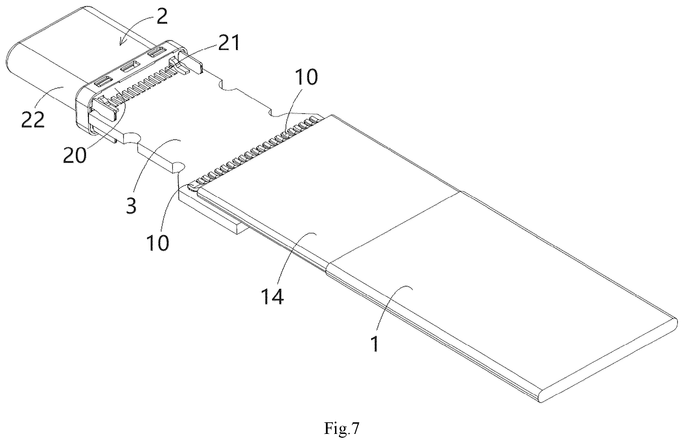

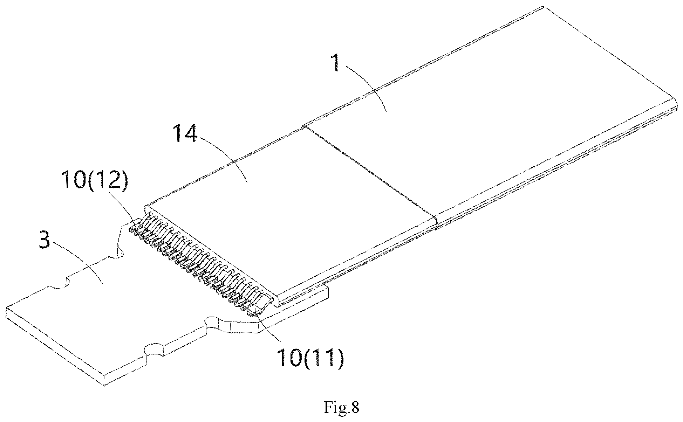

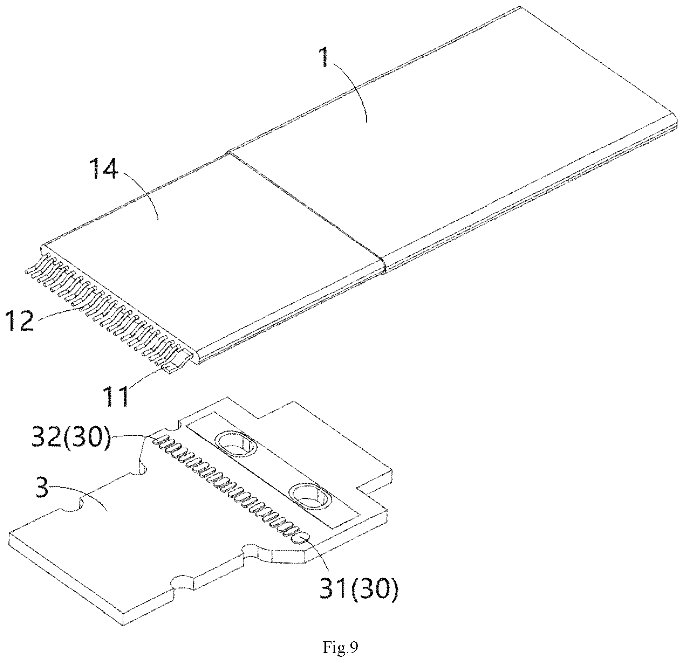

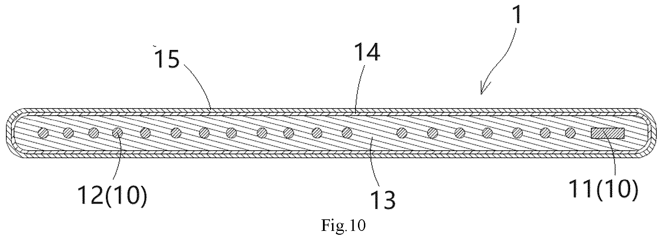

Figure 1 shows an illustrative perspective view of a connector assembly according to an exemplary embodiment of the present invention; Figure 2 shows an illustrative exploded view of a connector assembly according to an exemplary embodiment of the present invention; Figure 3 shows another illustrative exploded view of a connector assembly according to an exemplary embodiment of the present invention; Figure 4 shows an illustrative perspective view of a connector assembly according to an exemplary embodiment of the present invention, in which an outer insulating shell 8 and a rear end cover 9 are removed; Figure 5 shows an illustrative perspective view of an electrical connection module and a shield cover 5 of the connector assembly according to an exemplary embodiment of the present invention; Figure 6 shows an illustrative perspective view of an electrical connection module of a connector assembly according to an exemplary embodiment of the present invention; Figure 7 shows an illustrative perspective view of an electrical connection module of a connector assembly according to an exemplary embodiment of the present invention, with an insulator 4 not shown; Figure 8 shows an illustrative perspective view of a circuit board 3 and a flat cable 1 of a connector assembly according to an exemplary embodiment of the present invention; Figure 9 shows an illustrative exploded view of a circuit board 3 and a flat cable 1 of a connector assembly according to an exemplary embodiment of the present invention; and Figure 10 shows a cross-sectional view of a flat cable 1 of a connector assembly according to an exemplary embodiment of the present invention.

As shown in Figures 1 to 10, in an exemplary embodiment of the present invention, a connector assembly is disclosed. The connector assembly includes: a flat cable 1, a connector 2, a circuit board 3 and an insulator 4. The connector 2 includes a housing 20 and a plurality of terminals 21 disposed in the housing 20. The flat cable 1 includes a row of core wires 10 and an inner insulation layer 13 wrapping the row of core wires 10. Rear end of the plurality of terminals 21 protrudes from the housing 20 and is electrically connected to the circuit board 3, and front end of the row of core wires 10 is exposed from the inner insulation layer 13 and is welded to the circuit board 3. The insulator 4 is injection-molded onto the circuit board 3, the rear end of the plurality of terminals 21 and the front end of the row of core wires 10 through an embedded injection molding process, such that the insulator 4, the circuit board 3, the plurality of terminals 21 and the row of core wires 10 form an integral part.

As shown in Figures 1 to 10, in the illustrated embodiment, a row of pads 30 is formed on the circuit board 3, and the front end of the row of core wires 10 of the flat cable 1 is welded to the row of pads 30 of the circuit board 3 respectively.

As shown in Figures 1 to 10, in the illustrated embodiment, the row of core wires 10 of the flat cable 1 includes a plurality of different types of core wires 10 having different cross-sections and/or sizes. The row of pads 30 includes a plurality of different types of pads 30 corresponding to the plurality of different types of core wires 10 respectively.

As shown in Figures 1 to 10, in the illustrated embodiment, the row of core wires 10 of the flat cable 1 includes a flat core wire 11 having a rectangular cross-section and a circular core wire 12 having a circular cross-section. The row of pads 30 includes a first pad 31 corresponding to the flat core wire 11 and a second pad 32 corresponding to the circular core wire 12.

As shown in Figures 1 to 10, in the illustrated embodiment, a width of the flat core wire 11 is greater than a diameter of the circular core wire 12, and a thickness of the flat core wire 11 is equal to the diameter of the circular core wire 12. A width of the the first pad 31 is greater than a width of the second pad 32, and a thickness of the first pad 31 is equal to a thickness of the second pad 32.

As shown in Figures 1 to 10, in the illustrated embodiment, the row of core wires 10 includes a single flat core wire 11 and a plurality of circular core wires 12, and the single flat core wire 11 is a first core wire 10 or a last core wire 10 in the row of core wires 10.

As shown in Figures 1 to 10, in the illustrated embodiment, the plurality of terminals 21 of the connector 2 are arranged in an upper row and a lower row, the rear end of the terminals 21 in the upper row is welded to a front side of the circuit board 3, and the rear end of the terminals 21 in the lower row is welded to a back side of the circuit board 3.

As shown in Figures 1 to 10, in the illustrated embodiment, the connector 2 is a Type-C connector 2 conforming to a Type-C interface standard.

As shown in Figures 1 to 10, in the illustrated embodiment, the connector 2 further includes a shield case 22 sleeved on the housing 20, and a rear end of the shield case 22 is sleeved and locked to the insulator 4 to fix the connector 2 to a front end of the insulator 4.

As shown in Figures 1 to 10, in the illustrated embodiment, the flat cable 1 further includes: a shield layer 14 and an outer insulation layer 15. The shield layer 14 wraps around the inner insulation layer 13. The outer insulation layer 15 wraps around the shield layer 14. The connector assembly further includes a shield cover 5 mounted on the insulator 4. The rear end of the shield case 22 is inserted into a front end of the shield cover 5 and is in electric contact with the front end of the shield cover 5, and a rear end of the shield cover 5 is crimped onto the shield layer 14 of the flat cable 1 that is exposed from the outer insulation layer 15.

As shown in Figures 1 to 10, in the illustrated embodiment, a crimping portion 5a is formed at the rear end of the shield cover 5, and the crimping portion 5a is crimped onto the shield layer 14 of the flat cable 1.

As shown in Figures 1 to 10, in the illustrated embodiment, an elastic latch 5b is formed on the front end of the shield cover 5, an engagement groove 2b is formed in the rear end of the shield case 22, and the elastic latch 5b is locked into the engagement groove 2b to lock the rear end of the shield case 22 to the front end of the shield cover 5.

As shown in Figures 1 to 10, in the illustrated embodiment, an inwardly protruding contact protrusion 5c is formed on the shield cover 5, an opening 43 is formed on the insulator 4, a part of the circuit board 3 is exposed from the opening 43, and the contact protrusion 5c of the shield cover 5 is engaged into the opening 43 of the insulator 4 and is in electric contact with the circuit board 3.

As shown in Figures 1 to 10, in the illustrated embodiment, the shield cover 5 includes an upper shield cover 5 and a lower shield cover 5 assembled together, an elastic piece 5e is formed on a side wall of one of the upper shield cover 5 and the lower shield cover 5, a snap slot 5f is formed in the other one of the upper shield cover 5 and the lower shield cover 5, and the elastic piece 5e is locked into the snap slot 5f to lock the upper shield cover 5 and the lower shield cover 5 together.

As shown in Figures 1 to 10, in the illustrated embodiment, the connector assembly further includes an outer insulating shell 8, the outer insulating shell 8 is sleeved on the shield cover 5 and has a front port and a rear port opposite each other in an axial direction thereof. The flat cable 1 is led out from the rear port of the outer insulating shell 8, and a part of the connector 2 extends out of the front port of the outer insulating shell 8.

As shown in Figures 1 to 10, in the illustrated embodiment, the connector assembly further includes a rear end cover 9, the rear end cover 9 is sleeved on the flat cable 1 and is locked onto a rear end of the outer insulating shell 8 to retain the flat cable 1 to the outer insulating shell 8.

As shown in Figures 1 to 10, in the illustrated embodiment, the rear end cover 9 includes: a fixing portion 91 and a buffer portion 92. The fixing portion 91 is configured to be sleeved and locked onto the rear end of the outer insulating shell 8. The buffer portion 92 extends rearwardly from the fixing portion 91 and is capable of elastic deformation. The flat cable 1 passes through the buffer portion 92, and the buffer portion 92 is configured to provide stress buffer for the flat cable 1 to prevent the flat cable 1 from being damaged by bending.

As shown in Figures 1 to 10, in another exemplary embodiment of the present invention, a flat cable 1 is also disclosed. The flat cable 1 includes: a row of core wires 10 and an inner insulation layer 13. The inner insulation layer 13 wraps the row of core wires 10. One end of the row of core wires 10 is exposed from the inner insulation layer 13 and is configured to be welded to a circuit board 3 of a connector assembly. The row of core wires 10 includes a plurality of different types of core wires 10 having different cross-sections and/or sizes.

As shown in Figures 1 to 10, in the illustrated embodiment, the row of core wires 10 includes a flat core wire 11 having a rectangular cross-section and a circular core wire 12 having a circular cross-section.

As shown in Figures 1 to 10, in the illustrated embodiment, the flat cable 1 further includes a shield layer 14 and an outer insulation layer 15. The shield layer 14 wraps around the inner insulation layer 13. The outer insulation layer 15 wraps around the shield layer 14. One end of the shield layer 14 is exposed from the outer insulation layer 15 and is configured to be electrically connected to a shield cover 5 of the connector assembly.

It should be appreciated for those skilled in this art that the above embodiments are intended to be illustrated, and not restrictive. For example, many modifications may be made to the above embodiments by those skilled in this art, and various features described in different embodiments may be freely combined with each other without conflicting in configuration or principle.

Although several exemplary embodiments have been shown and described, it would be appreciated by those skilled in the art that various changes or modifications may be made in these embodiments without departing from the principles and spirit of the disclosure, the scope of which is defined in the claims and their equivalents.

As used herein, an element recited in the singular and proceeded with the word "a" or "an" should be understood as not excluding plural of said elements or steps, unless such exclusion is explicitly stated. Furthermore, references to "one embodiment" of the present invention are not intended to be interpreted as excluding the existence of additional embodiments that also incorporate the recited features. Moreover, unless explicitly stated to the contrary, embodiments "including" or "having" an element or a plurality of elements having a particular property may include additional such elements not having that property.

## Claims

1. A connector assembly, comprising:
a circuit board (3);
a connector (2) comprising a housing (20) and a plurality of terminals (21) disposed in the housing (20);
a flat cable (1) comprising a row of core wires (10) and an inner insulation layer (13) wrapping the row of core wires (10); and
an insulator (4);
wherein rear end of the plurality of terminals (21) protrudes from the housing (20) and are electrically connected to the circuit board (3), and front end of the row of core wires (10) is exposed from the inner insulation layer (13) and welded to the circuit board (3); and
wherein the insulator (4) is injection-molded onto the circuit board (3), the rear end of the plurality of terminals (21) and the front end of the row of core wires (10) through an embedded injection molding process, such that the insulator (4), the circuit board (3), the plurality of terminals (21) and the row of core wires (10) form an integral part.

2. The connector assembly according to claim 1,
wherein a row of pads (30) is formed on the circuit board (3), and the front end of the row of core wires (10) of the flat cable (1) is welded to the row of pads (30) of the circuit board (3) respectively.

3. The connector assembly according to claim 1,
wherein the row of core wires (10) of the flat cable (1) comprises a plurality of different types of core wires (10) having different cross-sections and/or sizes; and
wherein the row of pads (30) comprises a plurality of different types of pads (30) corresponding to the plurality of different types of core wires (10) respectively.

4. The connector assembly according to claim 1,
wherein the row of core wires (10) of the flat cable (1) comprises a flat core wire (11) having a rectangular cross-section and a circular core wire (12) having a circular cross-section; and
wherein the row of pads (30) comprises a first pad (31) corresponding to the flat core wire (11) and a second pad (32) corresponding to the circular core wire (12).

5. The connector assembly according to claim 4,
wherein a width of the flat core wire (11) is greater than a diameter of the circular core wire (12), and a thickness of the flat core wire (11) is equal to the diameter of the circular core wire (12); and
wherein a width of the first pad (31) is greater than a width of the second pad (32), and a thickness of the first pad (31) is equal to a thickness of the second pad (32).

6. The connector assembly according to claim 4,
wherein the row of core wires (10) comprises a single flat core wire (11) and a plurality of circular core wires (12), and the single flat core wire (11) is a first core wire (10) or a last core wire (10) in the row of core wires (10).

7. The connector assembly according to claim 1,
wherein the plurality of terminals (21) of the connector (2) are arranged in an upper row and a lower row, the rear end of the terminals (21) in the upper row are welded to a front side of the circuit board (3), and the rear end of the terminals (21) in the lower row are welded to a back side of the circuit board (3); and
wherein the connector (2) is a Type-C connector (2) conforming to a Type-C interface standard.

8. The connector assembly according to claim 1,
wherein the connector (2) further comprises a shield case (22) sleeved on the housing (20), and a rear end of the shield case (22) is sleeved and locked to the insulator (4) to fix the connector (2) to a front end of the insulator (4).

9. The connector assembly according to claim 8,
wherein the flat cable (1) further comprises:
a shield layer (14) wrapping around the inner insulation layer (13); and
an outer insulation layer (15) wrapping around the shield layer (14);
wherein the connector assembly further comprises:
a shield cover (5) mounted on the insulator (4);
wherein the rear end of the shield case (22) is inserted into a front end of the shield cover (5) and is in electric contact with the front end of the shield cover (5), and a rear end of the shield cover (5) is crimped onto the shield layer (14) of the flat cable (1) that is exposed from the outer insulation layer (15).

10. The connector assembly according to claim 9,
wherein a crimping portion (5a) is formed at the rear end of the shield cover (5), and the crimping portion (5a) is crimped onto the shield layer (14) of the flat cable (1).

11. The connector assembly according to claim 9,
wherein an elastic latch (5b) is formed on the front end of the shield cover (5), an engagement groove (2b) is formed in the rear end of the shield case (22), and the elastic latch (5b) is locked into the engagement groove (2b) to lock the rear end of the shield case (22) to the front end of the shield cover (5).

12. The connector assembly according to claim 9,
wherein an inwardly protruding contact protrusion (5c) is formed on the shield cover (5), an opening (43) is formed on the insulator (4), a part of the circuit board (3) is exposed from the opening (43), and the contact protrusion (5c) of the shield cover (5) is engaged into the opening (43) of the insulator (4) and in electric contact with the circuit board (3).

13. A flat cable, comprising:
a row of core wires (10); and
an inner insulation layer (13) wrapping the row of core wires (10);
wherein one end of the row of core wires (10) is exposed from the inner insulation layer (13) and is configured to be welded to a circuit board (3) of a connector assembly; and
wherein the row of core wires (10) comprises a plurality of different types of core wires (10) having different cross-sections and/or sizes.

14. The flat cable according to claim 13,
wherein the row of core wires (10) comprises a flat core wire (11) having a rectangular cross-section and a circular core wire (12) having a circular cross-section.

15. The flat cable according to claim 13, further comprising:
a shield layer (14) wrapping around the inner insulation layer (13); and
an outer insulation layer (15) wrapping around the shield layer (14);
wherein one end of the shield layer (14) is exposed from the outer insulation layer (15) and is configured to be electrically connected to a shield cover (5) of the connector assembly.
